# EUROPEAN PATENT APPLICATION

(11) **EP 4 560 710 A1**
(43) Date of publication of application: **28.05.2025**
(21) Application number: 23842964.1
(22) Date of filing: 18.07.2023
(51) Int. Cl.: H01L 31/05

(54) **SOLAR BATTERY MODULE**

(30) Priority: 21.07.2022 JP 2022116672
(71) Applicant: Sharp Kabushiki Kaisha, Sakai City, Osaka 590-8522 (JP)
(72) Inventor: OKAMOTO, Chikao, Sakai City, Osaka 590-8522 (JP); YOSHIKAWA FUNAKOSHI, Yasushi, Sakai City, Osaka 590-8522 (JP)
(74) Representative: Müller Hoffmann & Partner
(86) International application number: PCT/JP2023/026244
(87) International publication number: WO 2024/019041

(57) **Abstract**

A solar cell has electrodes in one surface of a semiconductor substrate. A solar cell module includes a plurality of the solar cells arranged in a first direction and in a second direction. The electrodes of the plurality of solar cells arranged in the first direction are connected by the wiring members such that the plurality of solar cells is connected in series. The electrodes of the plurality of solar cells arranged in the second direction are connected by the wiring members such that the plurality of solar cells is connected in parallel. Each of the wiring members includes a strip-shaped connection part extending in the second direction, and is disposed between the solar cells adjacent to each other in the first direction.

## Description

### Technical Field

The present disclosure relates to solar cell modules.

### Background Art

As a conventional solar cell module, a configuration is known, in which a plurality of solar cells each having a substantially rectangular shape is located between a transparent substrate and a protection member so as to be arranged in a matrix in a frame body. In this type of solar cell module, each of the plurality of solar cells in the matrix is connected in series to constitute a cell group, and this cell group is further connected to another cell group in series to constitute a solar cell string, and then, a plurality of solar cell strings is connected in parallel.

Also, a technology is known, in which a plurality of solar cells is disposed on a wiring sheet made of an insulating base material. One surface of the wiring sheet is provided with wiring members so as to connect electrodes of the solar cells, and the solar cells and wiring sheet are fixed by an adhesive such as a resin. For example, in Patent Document 1, a solar cell module is disclosed, in which solar cells and a wiring sheet are fixed by an adhesive so that a plurality of solar cells is electrically connected in series.

### Prior Art Document

### Patent Document

Patent Document 1: JP 2009-088145 A

### Summary of the Invention

### Problem to Be Solved by the Invention

In the above-described conventional solar cell module, if a building or the like casts a shadow over some solar cells or if foreign substances adhere to surfaces of solar cells, among the plurality of solar cells, these solar cells cannot receive sunlight. Even though the solar cell module has a bypass diode, the current does not flow through the bypass diode depending on the light-shielding rate of the solar cells, which results in no formation of the bypass path to bypass the shaded solar cells. In such a case, the shaded solar cell is in the reverse-bias condition, which causes local heat called a "hotspot" phenomenon. As a result, the solar cells and/or other components of the solar cell module are often damaged.

The present disclosure was made in consideration of the above circumstances, an object of which is to provide a solar cell module capable of reducing generation of a hotspot phenomenon and stabilizing a power generation amount.

### Means for Solving the Problem

In order to achieve the above object, a solar cell module of the present disclosure includes a plurality of solar cells each having electrodes on one surface of a semiconductor substrate so that the plurality of solar cells is electrically connected to each other by wiring members. The plurality of solar cells is arranged in a first direction and in a second direction orthogonal to the first direction. Each of the wiring members including a connection part extending in the second direction is shared by the plurality of solar cells arranged in the second direction, and is disposed between solar cells, in the plurality of solar cells, adjacent to each other in the first direction. The electrodes of the plurality of solar cells adjacent to each other in the first direction are connected by the wiring members such that the plurality of solar cells is connected in series. The electrodes of the plurality of solar cells arranged in the second direction are connected by the wiring members such that the plurality of solar cells is connected in parallel.

In the solar cell module having a configuration as described above, more specifically it is preferable that each of the plurality of solar cells includes, as the electrodes, first conductivity cell electrodes and second conductivity cell electrodes disposed alternately one by one and parallel to each other. Also, it is preferable that a first collector electrode is provided on a first part of the semiconductor substrate in the first direction so as to be connected to the first conductivity cell electrodes while a second collector electrode is provided on a second part of the semiconductor substrate in the first direction so as to be connected to the second conductivity cell electrodes. Furthermore, it is preferable that each of the wiring members includes: the connection part having a strip shape elongated in the second direction; and a plurality of tabs extending from the connection part in the first direction. It is also preferable that each of the plurality of tabs is connected to either the first collector electrode or the second collector electrode.

Also, in the solar cell module having a configuration as described above, it is preferable that each of the wiring members has a plurality of slits in the connection part, and that the plurality of slits is elongated in the second direction.

Also, in the solar cell module having a configuration as described above, it is preferable that each of the plurality of solar cells includes, as the electrodes, first conductivity cell electrodes and second conductivity cell electrodes disposed alternately one by one and parallel to each other. Also, it is preferable that a wiring sheet is provided by disposing the wiring members on an insulating base material, and that the wiring members include: a plurality of first wirings to be connected to the first conductivity cell electrodes; and a plurality of second wirings to be connected to the second conductivity cell electrodes. Furthermore, it is preferable that the plurality of solar cells is installed on the wiring sheet so as to be connected, by the wiring members, in series in the first direction and in parallel in the second direction.

In the above case, it is preferable that a first connection part and a second connection part each having a strip shape and extending in the second direction are provided, as the connection part, on the wiring sheet. Also, it is preferable that the plurality of first wirings extending from the first connection part in the first direction and the plurality of second wirings extending from the second connection part in the first direction are disposed alternately one by one and parallel to each other.

### Effects of the Invention

With the present disclosure, it is possible to stabilize the power generation amount even when some solar cells are in the reverse bias condition caused by light-shielding or the like.

### Brief Description of the Drawings

[FIG. 1]

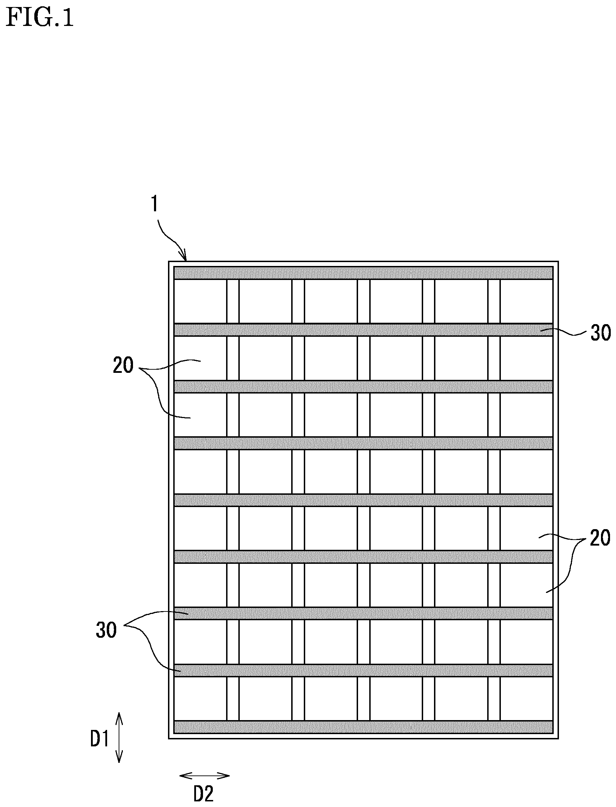

   FIG. 1 is a plan view schematically illustrating a configuration of a solar cell module according to embodiments of the present disclosure.
[FIG. 2]

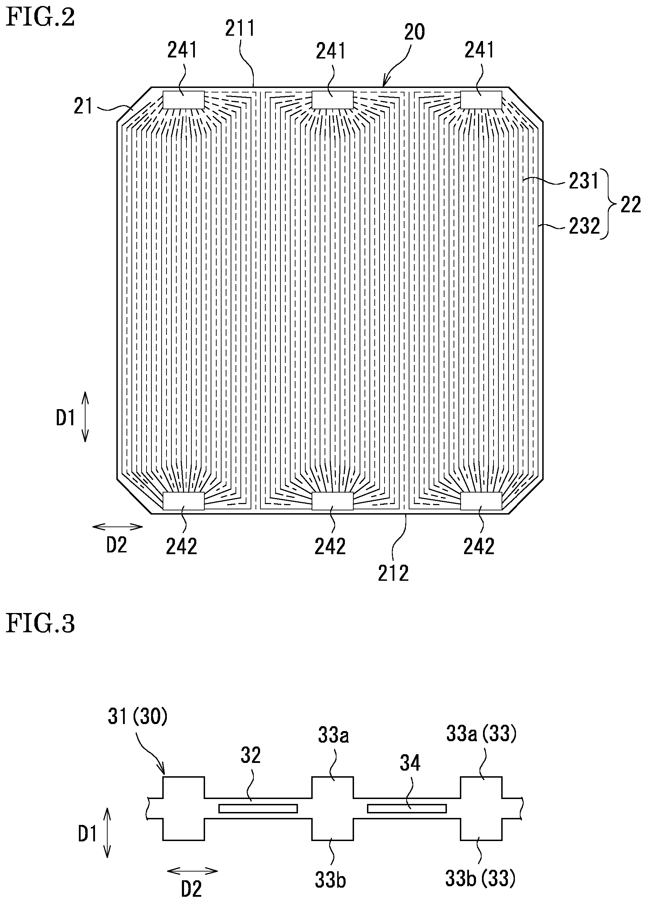

   FIG. 2 is a plan view schematically illustrating an electrode structure on a back surface side of the solar cell provided in the solar cell module according to Embodiment 1 of the present disclosure.
[FIG. 3]
   FIG. 3 is a plan view illustrating a part of a wiring member provided in the solar cell module.
[FIG. 4]

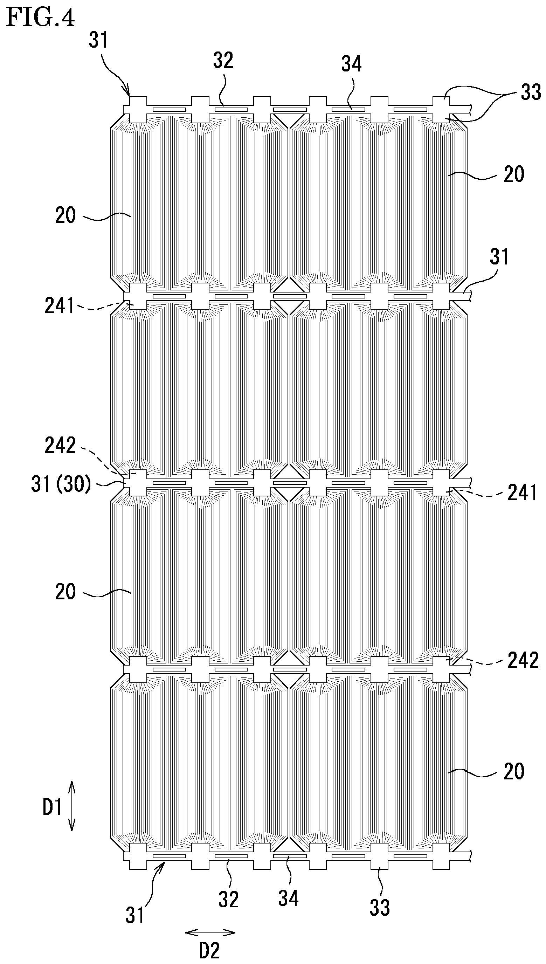

   FIG. 4 is a plan view illustrating a state in which the solar cells shown in FIG. 2 are connected by the wiring members, which is viewed from the back surface side.
[FIG. 5]

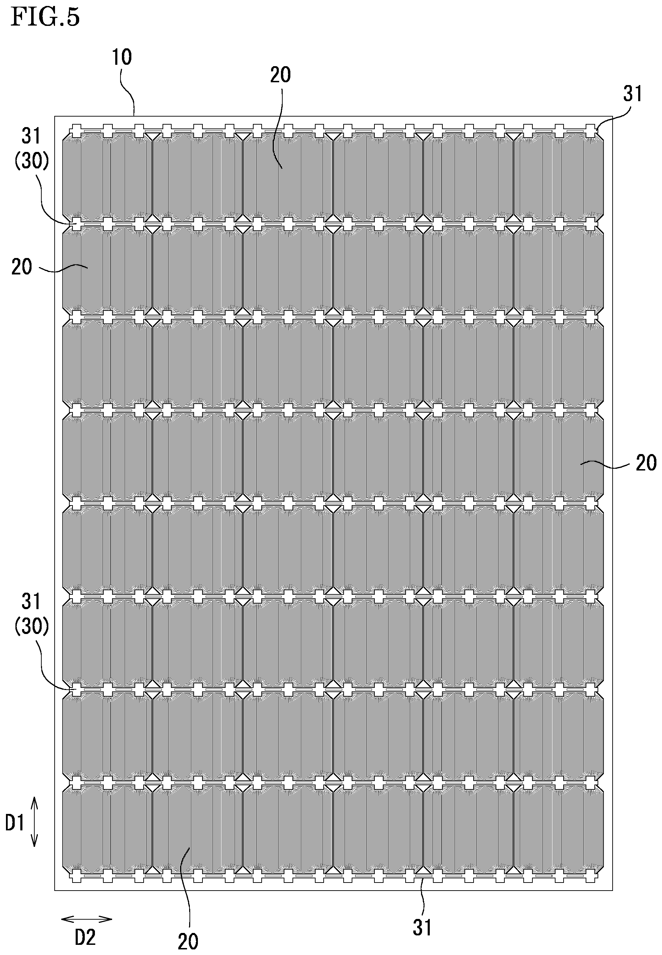

   FIG. 5 is a plan view illustrating the back surface of a solar cell assembly in which the plurality of solar cells is connected by the wiring members.
[FIG. 6]

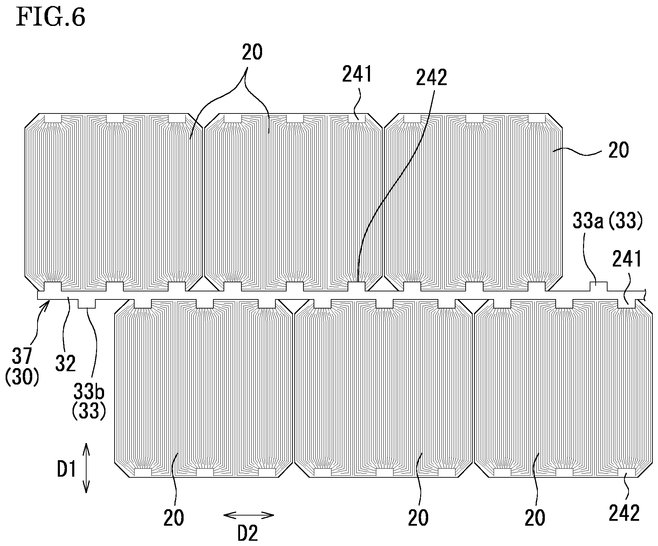

   FIG. 6 is a plan view illustrating a state in which a plurality of solar cells in the solar cell module according to Embodiment 2 of the present disclosure is connected by the wiring member, which is viewed from the back surface side.
[FIG. 7]

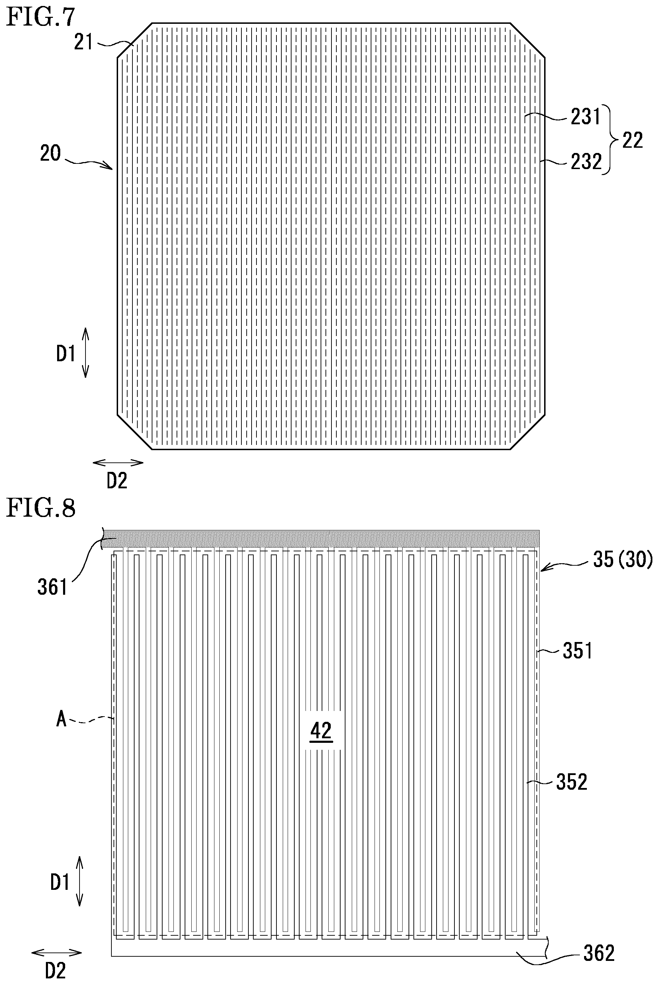

   FIG. 7 is a plan view schematically illustrating the electrode structure on the back surface side of the solar cell provided in the solar cell module according to Embodiment 3 of the present disclosure.
[FIG. 8]
   FIG. 8 is a plan view schematically illustrating a configuration example of the wiring members provided in the solar cell module.
[FIG. 9]

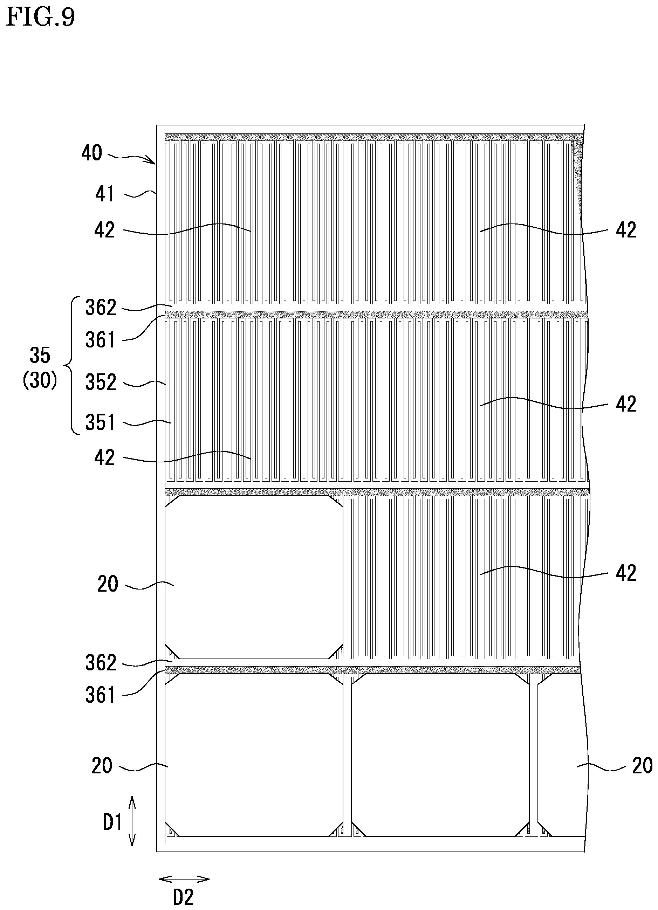

   FIG. 9 is a plan view illustrating an installation arrangement of a wiring sheet and the solar cells in the solar cell module.

### Modes for Carrying Out the Invention

Hereinafter, a solar cell module according to embodiments of the present disclosure will be described with reference to the drawings.

FIG. 1 is a plan view schematically illustrating a configuration of a solar cell module 1 according to the embodiments of the present disclosure.

FIG. 1 shows the solar cell module 1 viewed from the light-receiving surface side. The illustration of a resin layer, a protection member and the like provided in the solar cell module 1 is omitted here. Also, the illustration of the specific configuration of wiring members 30 provided in the solar cell module 1 is omitted, and the parts where the wiring members 30 are provided are shown in grey color.

The solar cell module 1 includes a plurality of solar cells 20 arranged to be separated from each other, and a plurality of wiring members 30 electrically connecting the plurality of solar cells 20. The plurality of solar cells 20 is arranged in a first direction D1 and in a second direction D2 orthogonal to the first direction D1.

The wiring member 30 has a strip-shaped connection part extending in the second direction D2. The wiring member 30 is provided between the solar cells 20 arranged adjacent to each other in the first direction D1. The wiring member 30 connects the plurality of solar cells 20 arranged in the first direction D1 so as to connect these solar cells 20 in series, and furthermore connects the plurality of solar cells 20 arranged in the second direction D2 so as to connect these solar cells 20 in parallel.

The specific configuration of the wiring member 30 as well as the connection configuration of the wiring members 30 and a plurality of solar cells 20 can be embodied in multiple aspects. Among the above embodiments, Embodiment 1 and Embodiment 2 will be described below.

### < Embodiment 1>

FIG. 2 is a plan view schematically illustrating an electrode structure on a back surface side of the solar cell 20 provided in the solar cell module 1 according to Embodiment 1. FIG. 3 is a plan view illustrating a part of a wiring member 31 provided in the solar cell module 1.

The aspect in FIG. 2 can be exemplarily shown as one of the plurality of solar cells 20 provided in the solar cell module 1 in FIG. 1. This solar cell 20 is a back surface electrode type (back contact type) solar cell that has electrodes 22 on the back surface opposite to the light-receiving surface. On the back surface side of a semiconductor substrate 21 of the solar cell 20, first conductivity (for example, n-type) cell electrodes 231 and second conductivity (for example, p-type) cell electrodes 232 are provided as the electrodes 22. In FIG. 2, the first conductivity cell electrodes 231 are shown by the broken lines while the second conductivity cell electrodes 232 are shown by the solid lines, for the purpose of easily distinguishing both electrodes.

The first conductivity cell electrodes 231 and the second conductivity cell electrodes 232 are respectively a number of straight electrodes extending in the same direction (in FIG. 2, in the first direction D1 as the vertical direction) on the back surface of the semiconductor substrate 21. The first conductivity cell electrodes 231 and the second conductivity cell electrodes 232 are arranged one by one alternately in parallel to each other at predetermined intervals.

In the vicinity of a first peripheral part 211 of the semiconductor substrate 21 of the solar cell 20 in the first direction D1, first collector electrodes 241 are provided so as to be each connected to a plurality of first conductivity cell electrodes 231. The first collector electrodes 241 are arranged at predetermined intervals in a direction along the first peripheral part 211 (i.e. in the second direction D2) of the semiconductor substrate 21. In the aspect exemplarily shown, 3 first collector electrodes 241 are formed on the first peripheral part 211 on the upper side of the solar cell 20 in FIG. 2.

In the same way, in the vicinity of a second peripheral part 212 of the semiconductor substrate 21 in the first direction D1, 3 second collector electrodes 242 are provided at predetermined intervals so as to be each connected to a plurality of second conductivity cell electrodes 232. The solar cell 20 is configured to be connected for extraction of electric power via the first collector electrodes 241 and the second collector electrodes 242.

As the semiconductor substrate 21, a silicon substrate may be used, which is made of polycrystalline silicon or monocrystalline silicon having the conductivity type of an n-type or a p-type. As the first conductivity cell electrode 231 and the second conductivity cell electrode 232, an electrode made of a metal such as silver may be used.

It is preferable that the light-receiving surface of the solar cell 20 is made uneven as a texture structure to serve as an anti-reflection structure (not shown) for preventing light reflection. Also, it is preferable that an anti-reflection film (not shown) having the physical property of preventing light reflection is formed on the anti-reflection structure on the light-receiving surface side. As the anti-reflection film, it is possible to use a silicon oxide film, a silicon nitride film, and a laminate of the silicon oxide film and the silicon nitride film. Also, on the back surface of the semiconductor substrate 21 on which the electrodes 22 are formed, a passivation film (an inactivation film, not shown) is preferably provided. As the passivation film, it is possible to use a silicon oxide film, a silicon nitride film, and a laminate of the silicon oxide film and the silicon nitride film.

In the solar cell module 1 according to Embodiment 1, the wiring member 31 shown in FIG. 3 can be exemplarily shown as the wiring member 30. The wiring member 31 includes: a connection part 32 extending in the second direction D2; and a plurality of tabs 33 provided on the connection part 32 to extend in the first direction D1.

As shown in FIG. 3, the connection part 32 has a strip shape elongated in the second direction D2. The tabs 33 (33a and 33b) are provided to respectively extend from the connection part 32 to the upper direction and the lower direction in FIG. 3. The tab 33a protruding in one direction of the first direction D1 (i.e. the upper direction in FIG. 3) and the tab 33b protruding in the other direction of the first direction D1 (i.e. the lower direction in FIG. 3) face each other with the connection part 32 being interposed therebetween.

In the connection part 32 of the wiring member 31, a plurality of slits 34 is formed. Each slit 34 is formed to have a rectangular shape elongated in the second direction D2, and located in a part between the adjacent tabs 33 in the second direction D2. The plurality of slits 34 is provided in the connection part 32 at an equal interval. Also, the wiring member 31 shown in FIG. 3 is continuously formed in the second direction D2. The length of the wiring member 31 (i.e. the length of the connection part 32) in the second direction D2 corresponds to the length of the solar cell module 1 in the second direction D2.

The wiring member 31 is made of a metal foil (for example, a copper foil) as conductor, and has a configuration in which the back surface of the connection part 32 except for the tabs 33 as the connection parts to the solar cell 20 is coated with an insulating adhesive. Since the slits 34 are formed in the connection part 32, it is possible to reduce the amount of the metal foil to be used to form the wiring member 31, which leads to reduction in manufacturing costs.

FIG. 4 is a plan view illustrating a state in which the solar cells 20 arranged adjacent to each other are connected by the wiring members 31, which is viewed from the back surface side. FIG. 5 is a plan view illustrating the back surface of a solar cell assembly 10 in which the plurality of solar cells 20 is connected by the wiring members 31.

In the plurality of solar cells 20 shown in FIG. 4, one solar cell 20 and another solar cell 20 arranged adjacent to each other in the first direction D1 are located facing each other in a manner that the second collector electrodes 242 of the one solar cell 20 make contact with the first collector electrodes 241 of the other solar cell 20. Also, one solar cell 20 and another solar cell 20 arranged adjacent to each other in the second direction D2 are located side by side in a manner that the respective peripheral parts of the one solar cell 20 and the other solar cell 20, which have neither the first collector electrodes 241 nor the second collector electrodes 242, make contact with each other.

The wiring members 31 are located along the peripheral parts, which extend in the second direction D2, of the plurality of solar cells 20 so as to bridge the plurality of solar cell 20 in the second direction D2. In the aspect exemplarily shown, the wiring members 31 are provided between the solar cells 20 arranged adjacent to each other in the first direction D1, and also provided at the peripheral parts of the solar cells 20 located on both end part in the first direction D1. The plurality of tabs 33a extending from the connection part 32 of the wiring member 31 in the first direction D1 is respectively connected to the second collector electrodes 242 of the solar cells 20, while the plurality of tabs 33b is respectively connected to the first collector electrodes 241 of the solar cells 20. For the above-described connection, it is possible to use a conductive adhesive such as a solder, a conductive solder resin, and a conductive paste.

The solar cells 20 arranged adjacent to each other in the first direction D1 are connected in series via the wiring member 31. The solar cells 20 arranged adjacent to each other in the second direction D2 are connected in parallel via the wiring member 31. One wiring member 31 is provided for a plurality of solar cells 20 adjacently arranged in the second direction D2.

In this way, a solar cell assembly 10 as shown in FIG. 5 is manufactured, by connecting, for example, 48 solar cells 20 arranged adjacent to one another (6 per line × 8 per column) by a plurality of wiring members 31. Furthermore, on the solar cell assembly 10, a sealing resin such as an EVA sheet and a transparent substrate are laminated on the light-receiving surface side of the solar cells 20 while a sealing resin such as an EVA sheet and a back surface sheet are laminated on the back surface side thereof so as to be subjected to lamination such as thermocompression bonding. Thus, the solar cell module 1 as shown in FIG. 1 is manufactured.

In this case, 8 solar cells 20 are arranged in the first direction D1 and electrically connected in series by the wiring members 31 (30). Also, 6 solar cells 20 are arranged side by side in the second direction D2 and electrically connected in parallel by one wiring member 31 (30) provided in the second direction D2.

Therefore, in the plurality of solar cells 20 in the matrix that constitutes the solar cell assembly 10 of the solar cell module 1 according to this embodiment, when any solar cell 20 is in the reverse bias condition due to shading or the like, it is considered that such a solar cell 20 whose current value decreases serves as electrical resistance. However, since the solar cell module 1 has both connection structures, i.e. the solar cells 20 connected in series and the solar cells 20 connected in parallel, the current flows through the parallel connection circuit avoiding this solar cell 20. Thus, it is possible to overcome the problem of decrease of the current value of one solar cell 20 limited by the lowered current value of the other solar cell 20.

Thus, it is possible to prevent reduction in the power generation amount of the solar cell module 1 caused by shading or the like, which leads to the stable power generation amount. Also, it is possible to reduce generation of local heat that is called a hotspot phenomenon, which leads to reduction in the risk of damage of the solar cells 20.

### <Embodiment 2>

FIG. 6 is a plan view illustrating a state in which a plurality of solar cells 20 in the solar cell module 1 according to Embodiment 2 of the present disclosure is connected by a wiring member 37, which is viewed from the back surface side.

In the solar cell module 1 according to this embodiment, the arrangement of the solar cells 20 and the configuration of the wiring member 37 are the characteristic features, and the basic configuration other than the above is the same as that in Embodiment 1. Therefore, the above characteristic features are described here, and the configuration that is common to Embodiment 1 is omitted to avoid duplication. Also in FIG. 6, the same reference numerals as those in Embodiment 1 are used in Embodiment 2 to indicate the same or corresponding parts.

The arrangement and the connection structure of the plurality of solar cells 20 included in the solar cell module 1 are not limited to those described in Embodiment 1, but various other structures may be embodied. Here, the configuration of the solar cell 20 may be the same as that shown in FIG. 2.

As shown in FIG. 6, the plurality of solar cells 20 is arranged adjacent to each other in the second direction D2 in a manner that the respective peripheral parts in the first direction D1 not having neither the first collector electrodes 241 nor the second collector electrodes 242 make contact with each other.

On the other hand, one solar cell 20 is arranged adjacent to another solar cell 20 in the first direction D1 such that the other solar cell 20 is shifted by half the width of the solar cell 20 with respect to the one solar cell 20 in the second direction D2. Thus, in these adjacent solar cells 20, the second collector electrodes 242 of the one solar cell 20 do not face the first collector electrodes 241 of the other solar cell 20 but are shifted from each other in the second direction D2.

Thus, the plurality of solar cells 20 that constitutes the solar cell module 1 is arranged adjacent to each other in the second direction D2. Also, the solar cell 20 on the *n*-th line and the solar cell 20 on the (*n*+*1*) th line in the second direction D2 are arranged so as to be close to a composite direction of the first direction D1 and the second direction D2. In this way, the plurality of solar cells 20 is arranged all over the solar cell module 1.

As the wiring member 30 used in the case where the solar cells 20 are arranged to be shifted in the second direction D2, the wiring member 37 in FIG. 6 can be exemplarily shown. This wiring member 37 includes: the connection part 32 extending in the second direction D2; and the plurality of tabs 33 provided on the connection part 32 to extend in the first direction D1. The respective tabs 33a protruding in one direction of the first direction D1 (i.e. the upper direction in FIG. 6) are not located to face the respective tabs 33b protruding in the other direction of the first direction D1 (i.e. the lower direction in FIG. 6) with the connection part 32 being interposed therebetween. Both the tabs 33a and the tabs 33b are located respectively at even intervals in the second direction D2 while alternately protruding in the first direction D1.

One wiring member 37 is provided so as to be shared by the plurality of solar cells 20 arranged in the second direction D2. The wiring members 37 are continuously located along the peripheral parts, which extend in the second direction D2, of the plurality of solar cells 20 so as to extend by bridging the plurality of solar cells 20 in the second direction D2. The plurality of tabs 33a of the wiring member 37 is respectively connected to the first collector electrodes 241 of the solar cells 20 arranged as described above, while the plurality of tabs 33b is respectively connected to the second collector electrodes 242 of the solar cells 20.

The solar cell module 1 according to Embodiment 2 also has both connection structures, i.e. the solar cells 20 connected in series and the solar cells 20 connected in parallel, and thus, even when any solar cell 20 is in the reverse bias condition due to shading or the like, the current flows through the parallel connection circuit avoiding this solar cell 20. Therefore, it is possible to overcome the problem of decrease of the current value of the other solar cells 20. Also, it is possible to reduce generation of local heat that is called a hotspot phenomenon, which leads to reduction in the risk of damage of the solar cells. Furthermore, the plurality of solar cells 20 is located to be shifted in the second direction D2, which allows the solar cell module 1 to have not only the rectangular shape but also various shapes to fit an installation space. Thus, it is possible to effectively use the installation space, which leads to high designability.

### <Embodiment 3>

FIGS. 7 to 9 are diagrams related to the solar cell module 1 according to Embodiment 3 of the present disclosure. FIG. 7 is a plan view schematically illustrating the electrode structure on the back surface side of the solar cell 20 provided in the solar cell module 1. FIG. 8 is a plan view schematically illustrating a configuration example of wiring members 35 provided in the solar cell module 1. FIG. 9 is a plan view illustrating an arrangement of a wiring sheet 40 and the solar cells 20 in the solar cell module 1.

This solar cell 20 is a back surface electrode type solar cell as described above. As shown in FIG. 7, the solar cell 20 includes, as the electrodes 22, the first conductivity cell electrodes 231 and the second conductivity cell electrodes 232. However, the solar cell 20 is provided with neither the first collector electrodes 241 connected to the first conductivity cell electrodes 231 nor the second collector electrodes 242 connected to the second conductivity cell electrodes 232 as shown in FIG. 2. A plurality of linear first conductivity cell electrodes 231 and a plurality of linear second conductivity cell electrodes 232 are alternately provided in parallel to each other on the back surface side of the semiconductor substrate 21.

In the solar cell module 1 according to this embodiment, the wiring members 30 connecting the plurality of solar cells 20 are not necessarily required to have the configuration described in Embodiments 1 and 2. As shown in this embodiment, the wiring members 30 may be a wiring members 35 formed on an insulating base material 41 to constitute the wiring sheet 40.

As shown in FIG. 9, the wiring sheet 40 includes: a plate-like insulating base material 41; and the wiring members 35 made of conductor disposed on one surface of the insulating base material 41. The wiring sheet 40 electrically connects the plurality of solar cells 20 having the configuration described above.

As the insulating base material 41, any electrical insulating materials may be used without particular limitation. For example, it is possible to use a substrate made of materials including a synthetic resin material such as polyethylene terephthalate (PET), polyethylene naphthalate (PEN), polyphenylene sulfide (PPS), polyvinyl fluoride (PVF), and polyimide. Also, the insulating base material 41 may have a single layer structure or a multilayer structure.

As enlarged and shown in FIG. 8, the wiring members 35 include: a plurality of first wirings 351; and a plurality of second wirings 352. The first wirings 351 and the second wirings 352 are linearly provided along the first direction D1, and furthermore are arranged one by one alternately at a certain distance. Also, the wiring members 35 are provided with a first connection part 361 and a second connection part 362 as the connection parts extending in the second direction D2.

The plurality of first wirings 351 extend in the same direction from the strip-shaped first connection part 361 elongated in the second direction D2. Also, the plurality of second wirings 352 extend in the same direction from the strip-shaped second connection part 362 elongated in the second direction D2. In FIGS. 8 and 9, the first wirings 351 and the first connection part 361 are indicated in grey color in order to easily distinguish them from the second wirings 352 and the second connection part 362. Also, the respective numbers of the first wirings 351 and the second wirings 352 in FIG. 8 are schematically indicated only for the purpose of visibility, which never limits the actual number of the wirings.

The wiring member 35 is made of conductor containing, for example, copper as a main material, and thus can be formed by a strip-shaped conductor (ribbon wire), a rectangular wire, or a copper foil wire. However, the wiring member 35 is not limited thereto. For example, it may be made of a highly conductive metal such as gold, silver, aluminum, and nickel, or may be made of an alloy or a multiple metal laminate both containing the above metals. Also, the wiring member 35 may be a plane pattern or a wire pattern formed by directly applying normal leads or a paste-like electrode material on the insulating base material 41 using inkjet method.

On the wiring sheet 40, the plurality of first wirings 351 and the first connection part 361 connected to the respective first wirings 351 are formed to have a substantially comb shape. Similarly to the above, the plurality of second wirings 352 and the second connection part 362 connected to the respective second wirings 352 are also formed to have a substantially comb shape. The first wirings 351 and the second wirings 352 that correspond to the teeth of the comb shape are located so that respective teeth 351 and 352 are engaged with one by one, alternately.

As shown in FIG. 8, a region A having a substantially rectangular shape made by combination of the plurality of first wirings 351 and the plurality of second wirings 352 is an installation part 42 for one solar cell 20. As shown in FIG. 9, on the insulating base material 41 of the wiring sheet 40, the installation parts 42 corresponding to the plurality of solar cells 20 are formed. The number of the installation parts 42 formed on the wiring sheet 40 for the solar cells 20 is not particularly limited. For example, the number of the installation parts 42 may be 30, 42, or 48, that is, any configuration may be applied.

The second connection part 362 and the first connection part 361 both extending in the second direction D2 are arranged adjacent to each other on the insulating base material 41. Also, the first connection part 361 and the second connection part 362 are each formed in a strip shape elongated in the second direction D2, and continuously provided over the entire wiring sheet 40.

As shown in FIG. 9, a plurality of solar cells 20 are installed on the wiring sheet 40. Specifically, the electrodes 22 of the back surface of the solar cell 20 are superimposed on the installation part 42 of the wiring sheet 40. In FIG. 9, the light-receiving surface side of the solar cell 20 is indicated.

On each installation part 42 of the wiring sheet 40, the first conductivity cell electrodes 231 and the second conductivity cell electrodes 232 on the back surface of the solar cell 20 are respectively connected to the first wirings 351 and the second wirings 352 of the wiring members 35 via a conductive adhesive or the like. By installing the solar cells 20 on the entire wiring sheet 40, the back surface electrode type solar cells with wiring sheet can be manufactured. Furthermore, the solar cell module 1 shown in FIG. 1 can be manufactured by disposing, in the following order from the light-receiving surface side: the transparent substrate; the sealing resin; the back surface electrode type solar cells with wiring sheet; the sealing resin; and the back surface sheet, so as to be subjected to the thermocompression bonding.

Also in the solar cell module 1 using the wiring sheet 40 including the wiring members 35, the plurality of solar cells 20 is connected in series in the first direction D1 by the wiring members 35. In the second direction D2, the first connection parts 361 and the second connection parts 362 are respectively continuously provided. Also, such continuously provided first connection parts 361 and second connection parts 362 are integrally provided with each other. Thus, the plurality of solar cells 20 is connected in parallel in the second direction D2.

The solar cell module 1 according to Embodiment 3 also has both connection structures, i.e. the solar cells 20 connected in series and the solar cells 20 connected in parallel, and thus, even when any solar cell 20 is in the reverse bias condition due to shading or the like, the current flows through the parallel connection circuit avoiding this solar cell 20. Therefore, it is possible to overcome the problem of decrease of the current value of the other solar cells 20. Also, it is possible to reduce generation of local heat that is called a hotspot phenomenon, which leads to reduction in the risk of damage of the solar cells.

As described above, in the solar cell module 1 of the present disclosure, even when shading or the like of the solar cell 20 occurs, it is possible to prevent reduction in the power generation amount of the solar cell module 1 and to stabilize the power generation amount. Also, it is possible to prevent generation of the hotspot phenomenon, which leads to reduction in the risk of damage of the solar cells.

The solar cell module 1 of the present disclosure is not limited to the above-described configurations, but it can have various other configurations. For example, the solar cell module 1 can be suitably applied to a solar cell module having a curved surface shape.

The kind of the solar cell 20 provided in the solar cell module 1 is not particularly limited, and various semiconductor materials such as a polycrystalline semiconductor and a thin film semiconductor may be applied.

Also, the solar cell 20 is not limited to a standard sized solar cell (a cell corresponding to one solar cell wafer, also called a "full cell"), which is exemplarily described. The solar cell 20 may be a split cell made by dividing the standard sized cell in half (half cell), or made by dividing the standard sized cell into three (size of one-third) or into four (size of one-fourth). Also, the electrode structure of the back surface of the solar cell 20 is not limited to the examples shown in FIGS. 2 and 7. The shape and the number of the first conductivity cell electrodes 231 and the second conductivity cell electrodes 232 may have any other configurations. Other than the above-described embodiments, it is possible to configure the solar cell module 1 that varies in the number of the solar cells 20 arranged in series, by using the wiring members 30 and the wiring sheet 40. As to the solar cell module 1, it may have a configuration in which the plurality of solar cells 20 is arranged variously in the first direction D1 and the second direction D2.

The aforementioned embodiments and examples are for only illustrative purposes in every respect and provide no basis for restrictive interpretations. The technical scope of the present disclosure is defined only by the claims and never bound by the embodiments and examples. Any modifications and variations that may lead to equivalents of claimed elements are all included within the scope of the disclosure.

This application claims priority based on Patent Application No. 2022-116672 filed in Japan on July 21, 2022. The entire contents thereof are hereby incorporated in this application by reference.

### Description of the Reference Numerals

- 1: Solar cell module
- 10: Solar cell assembly
- 20: Solar cell
- 21: Semiconductor substrate
- 22: Electrode
- 231: First conductivity cell electrode
- 232: Second conductivity cell electrode
- 241: First collector electrode
- 242: Second collector electrode
- 30, 31, 35, 37: Wiring member
- 32: Connection part
- 33, 33a, 33b: Tab
- 34: Slit
- 351: First wiring
- 352: Second wiring
- 361: First connection part (connection part)
- 362: Second connection part (connection part)
- 40: Wiring sheet
- 41: Insulating base material
- 42: Installation part
- D1: First direction
- D2: Second direction

## Claims

1. A solar cell module comprising a plurality of solar cells each having electrodes on one surface of a semiconductor substrate so that the plurality of solar cells is electrically connected to each other by wiring members, wherein
the plurality of solar cells is arranged in a first direction and in a second direction orthogonal to the first direction,
each of the wiring members including a connection part extending in the second direction is shared by the plurality of solar cells arranged in the second direction, and is disposed between solar cells, in the plurality of solar cells, adjacent to each other in the first direction,
the electrodes of the plurality of solar cells adjacent to each other in the first direction are connected by the wiring members such that the plurality of solar cells is connected in series, and
the electrodes of the plurality of solar cells arranged in the second direction are connected by the wiring members such that the plurality of solar cells is connected in parallel.

2. The solar cell module according to claim 1, wherein
each of the plurality of solar cells includes, as the electrodes, first conductivity cell electrodes and second conductivity cell electrodes disposed alternately one by one and parallel to each other,
a first collector electrode is provided on a first part of the semiconductor substrate in the first direction so as to be connected to the first conductivity cell electrodes, and a second collector electrode is provided on a second part of the semiconductor substrate in the first direction so as to be connected to the second conductivity cell electrodes,
each of the wiring members includes: the connection part having a strip shape elongated in the second direction; and a plurality of tabs extending from the connection part in the first direction, and
each of the plurality of tabs is connected to either the first collector electrode or the second collector electrode.

3. The solar cell module according to claim 2, wherein
each of the wiring members has a plurality of slits in the connection part, and the plurality of slits is elongated in the second direction.

4. The solar cell module according to claim 1, wherein
each of the plurality of solar cells includes, as the electrodes, first conductivity cell electrodes and second conductivity cell electrodes disposed alternately one by one and parallel to each other,
a wiring sheet is provided by disposing the wiring members on an insulating base material, and the wiring members include: a plurality of first wirings to be connected to the first conductivity cell electrodes; and a plurality of second wirings to be connected to the second conductivity cell electrodes, and
the plurality of solar cells is installed on the wiring sheet so as to be connected, by the wiring members, in series in the first direction and in parallel in the second direction.

5. The solar cell module according to claim 4, wherein
a first connection part and a second connection part each having a strip shape and extending in the second direction are provided, as the connection part, on the wiring sheet, and
the plurality of first wirings extending from the first connection part in the first direction and the plurality of second wirings extending from the second connection part in the first direction are disposed alternately one by one and parallel to each other.
